(19) Europäisches Patentamt
European Patent Office
Office européen des brevets

(11) EP 0 561 676 B1

(12) FASCICULE DE BREVET EUROPEEN

(45) Date de publication et mention
de la délivrance du brevet:
16.07.1997 Bulletin 1997/29

(51) Int Cl.⁶: **H03H 7/12**, H03J 3/26

(21) Numéro de dépôt: 93400636.2

(22) Date de dépôt: 12.03.1993

(54) **Filtre accordable haute fréquence**

Abstimmbares Hochfrequenzfilter

High frequency tunable filter

(84) Etats contractants désignés:
BE CH DE ES GB IT LI NL

(30) Priorité: 17.03.1992 FR 9203161

(43) Date de publication de la demande:
22.09.1993 Bulletin 1993/38

(73) Titulaire: THOMSON-CSF
75008 Paris (FR)

(72) Inventeurs:
• **Duflot, Bernard**
**F-92402 Courbevoie Cedex (FR)**
• **Byzery, Michel**
**F-92402 Courbevoie Cedex (FR)**

(74) Mandataire: **Lincot, Georges et al**
**THOMSON-CSF-S.C.P.I.,**
**13, Avenue du Président**
**Salvador Allende**
**94117 Arcueil Cédex (FR)**

(56) Documents cités:
EP-A- 0 125 586          FR-A- 2 555 847

• PATENT ABSTRACTS OF JAPAN vol. 07, no. 174
(E-190)2 Août 1983 &JP-A-58 081 340

# Description

La présente invention concerne un filtre accordable haute fréquence. Elle s'applique notamment à la réalisation de filtres miniatures destinés à équiper les têtes de réception haute fréquence des récepteurs radioélectriques "VHF" fonctionnant en évasion de fréquence, "VHF" étant l'abréviation anglosaxonne de "Very Hight Frequency".

Dans les récepteurs radioélectriques fonctionnant en évasion de fréquence, il est connu de disposer au pied de l'antenne de réception un filtre pour assurer les fonctions de filtrage, de sélectivité et de rejection des fréquences image pour permettre l'accord du récepteur sur les fréquences de réception.

Dans les gammes de fréquence 30-88 MHZ ou 68-150 MHZ ce filtre est classiquement réalisé de la façon décrite par exemple dans le demande de brevet FR 2 555 847 sous la forme de deux circuits oscillants parallèles accordés par des diodes à capacité variable, encore connues sous les désignations "Varicap" ou "Varactor", couplés l'un à l'autre par mutuelle induction.

Cependant pour la réalisation de postes radioélectriques portables ou portatifs de petite dimension l'encombrement pris par ces filtres est très important à cause de l'écartement qui est imposé aux deux circuits oscillants pour réaliser le couplage par mutuelle induction. D'autre part, lorsque ces filtres doivent fonctionner sur des gammes de fréquence étendues, le réglage de l'écartement entre les deux circuits oscillants pour qu'ils restent dans leur mode de couplage critique est délicat à réaliser, et pour des gammes d'accord en fréquence très importantes couvrant par exemple deux à trois octaves sur des paliers de fréquence n'excédant pas 10 ms, ce mode de couplage ne permet pas aux circuits oscillants de rester dans un couplage critique sur toute la gamme de fréquence.

Le but de l'invention est de pallier les inconvénients précités.

A cet-effet, l'invention a pour objet un filtre accordable haute fréquence comportant un premier et un deuxième circuits oscillants accordés par des diodes à capacité variable commandées en tension, comprenant des diodes à capacité variable couplées entre les premier et deuxième circuits oscillants, les diodes à capacité variable d'accord des circuits oscillants et les diodes à capacité variable de couplage entre les premier et deuxième circuits oscillants étant commandées par une même tension de commande pour réaliser l'accord du filtre sur sa fréquence de travail et le couplage critique des deux circuits oscillants caractérisé en ce que la capacité de couplage résultante entre les deux circuits oscillants est environ $Q_c$ fois plus faible que la capacité résultante nécessaire à l'accord de chaque circuit oscillant, $Q_c$ étant le coefficient de surtension en charge du filtre.

La mise en oeuvre de diodes à capacité variable pour la réalisation du couplage entre les deux circuits oscillants a pour principaux avantages de réduire l'encombrement des filtres réalisés suivant ce principe et de permettre par une commande en tension unique, l'accord des circuits oscillants et la mise au couplage critique de ces deux circuits. Ceci permet d'assurer une bonne sélectivité du filtre sur une bande de fréquence étendue.

D'autre caractéristiques et avantages de l'invention apparaîtront ci-après à l'aide de la description qui suit faite en regard des figures annexées qui représentent:

- la figure 1, un premier mode de réalisation d'un filtre selon l'invention ;
- la figure 2, un deuxième mode d'assemblage de diodes à capacité variable pour réaliser le couplage entre les deux circuits oscillants du filtre de la figure 1 ;
- la figure 3, un deuxième mode de réalisation d'un filtre selon l'invention.

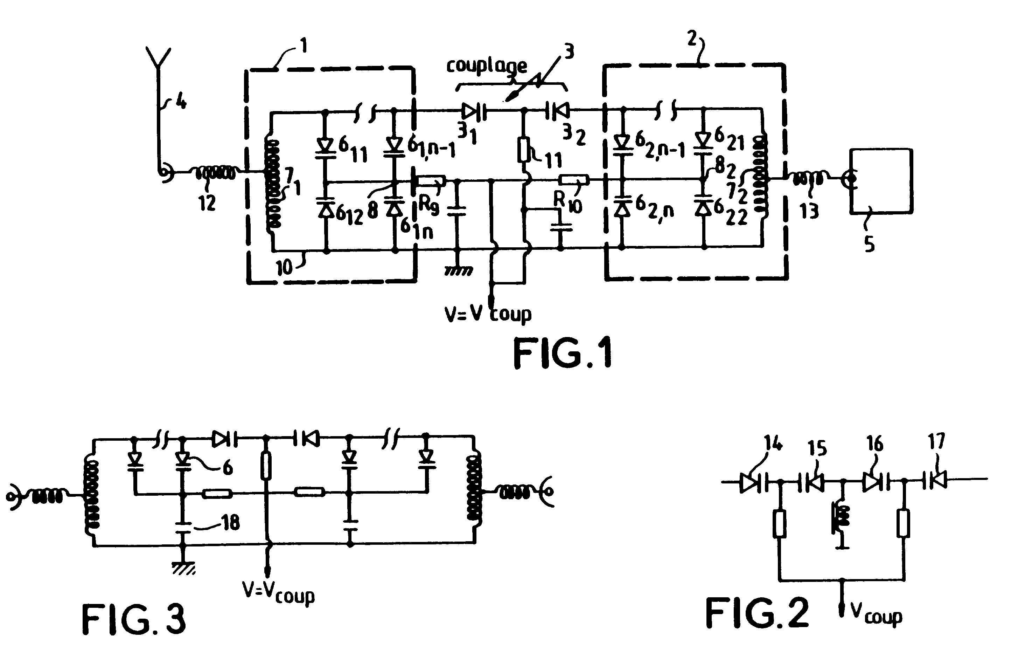

Le filtre qui est représenté à la figure 1 comprend des premier 1 et deuxième 2 circuits oscillants accordables par tension, couplés entre eux par des diodes à capacité variable 3 disposé entre une antenne de réception 4 et un premier étage de réception d'un récepteur radio 5. Chaque circuit oscillant comporte des couples de diodes à capacité variable, montées tête-bêche, référencées respectivement $6_{11}$--$6_{2n}$ et branchées en parallèle aux bornes d'une inductance $7_1$, respectivement $7_2$. Les points communs $8_1$ et $8_2$ à chaque paire de diodes 6 sont reliés à travers de résistances R9 et R10 (voir figure 1) et sont polarisés par une tension V d'accord appliquée par leur intermédiaire. Une des deux extrémités de chacune des inductances 7 est reliée à un circuit de masse commun 10. Leurs deuxièmes extrémités sont couplées l'une à l'autre par l'intermédiaire de deux diodes à capacité variable $3_1$, $3_2$, montées tête-bêche et en série. Ces diodes réalisent un couplage capacitif entre les deux circuits oscillants 1 et 2. Le point commun aux deux diodes de couplage est polarisé par une tension $V_{coup}$ au travers d'une résistance de polarisation 11. Chacune des inductances $7_1$, $7_2$ d'un circuit oscillant possède une prise qui est couplée respectivement à l'antenne 4 et à l'étage d'entrée du récepteur 5 au travers respectivement d'inductances 12, 13. Ce système permet d'obtenir une surtension en charge constante dans la bande de fréquence utilisée.

Le mode de couplage par diodes à capacité variable qui est ainsi réalisé permet grâce à un choix judicieux des capacités des diodes de rester le plus longtemps possible au voisinage du couplage critique entre les deux circuits oscillants 1 et 2 dans la gamme des fréquences utilisées et d'assurer un fonctionnement du filtre en évasion de fréquence avec une agilité suffisante.

Ce choix résulte des considérations suivantes. En considérant, par exemple, un filtre à 2n diodes à capacité variable par circuit oscillant et en désignant par :

$C_{acc}$ la capacité d'une diode et par $Q_c$ le coefficient de surtension en charge du filtre, la valeur de la capacité de couplage de la diode à capacité variable nécessaire pour rester au couplage critique est alors définie par la relation :

$$C_{coup} = (n.C_{acc})/2.Q_c \qquad (1)$$

Comme la loi de variation de la capacité $C_v$ d'une diode varicap en fonction de la tension de polarisation V qui lui est appliquée est de la forme :

$$C_{(V)} = C_o (1 + V/\emptyset)^{-\gamma} \qquad (2)$$

où : $C_O$ est la capacité à V = O Volt,

- $\gamma$ est la pente de variation (capacité-tension) de la diode varicap
- et $\emptyset$ est le potentiel de contact

en remplaçant dans l'équation (1) $C_{acc}$ par $C_{(V)}$, la loi de variation de la capacité de couplage est alors

$$C_{coup} = n.C_O/[2Q_c(1+V/\emptyset)^{\gamma}] \qquad (3)$$

En rapprochant les relations (2) et (3), il apparait que la capacité de couplage doit avoir environ une capacité $Q_c$ fois plus faible que les diodes à capacité variable d'accord totales mise en oeuvre dans chaque circuit oscillant du filtre.

Naturellement la valeur de la capacité de couplage peut être obtenue suivant les besoins par la mise en série d'un nombre plus ou moins important de diodes à capacité variable suivant le type de diodes à capacité variable utilisées et notamment de la manière représentée par exemple à la figure 2 où celle-ci est réalisée à la différence de la figure 1 à l'aide de deux paires de diodes à capacité variable 14 à 17 reliées en série.

Egalement, comme le montre la figure 3, les couples de diodes à capacité variable, montées tête-bêche en parallèle aux bornes des inductances $7_1$, $7_2$ de la figure 2 peuvent être aussi bien remplacés par des couples formés par la mise en série d'au moins une capacité 18 avec une diode à capacité variable 6. Dans ce cas, les relations (1) et (3) donnent la valeur $C_{coup}$ à multiplier par deux.

## Revendications

1. Filtre accordable haute fréquence comportant un premier (1) et un deuxième (2) circuits oscillants accordés par des diodes à capacité variable (3) commandées en tension, comprenant des diodes à capacité variable (6) couplées entre les premier et deuxième circuits oscillants, les diodes à capacité variable (3) d'accord des circuits oscillants et les diodes à capacité variable de couplage entre les premier et deuxième circuits oscillants étant commandées par une même tension de commande (V) pour réaliser l'accord du filtre sur sa fréquence de travail et le couplage critique des deux circuits oscillants (1, 2), caractérisé en ce que la capacité de couplage résultante entre les deux circuits oscillants est environ $Q_c$ fois plus faible que la capacité résultante nécessaire à l'accord de chaque circuit oscillant, $Q_c$ étant le coefficient de surtension en charge du filtre.

2. Filtre selon la revendication 1, caractérisé en ce que chaque circuit oscillant comprend une inductance (7) et au moins une paire de diodes à capacité variable (3) montées tête-bêche en parallèle sur l'inductance.

3. Filtre selon la revendication 1, caractérisé en ce que chaque circuit oscillant comprend une inductance (7) accordée en parallèle par des diodes à capacité variable reliées (6) en série avec au moins une capacité (18).

4. Filtre selon la revendication 1, caractérisé en ce que les diodes à capacité variable (6) couplées entre les premier et deuxième circuits oscillants (1, 2) sont montées par paire de diodes tête-bêche en série.

5. Filtre selon la revendication 4, caractérisé en ce que les premier (1) et deuxième (2) circuits oscillants sont couplés respectivement à une antenne de réception radioélectrique (4) et à l'entrée d'un poste récepteur radioélectrique (5).

## Patentansprüche

1. Abstimmbares Hochfrequenzfilter, mit einem ersten Schwingkreis (1) und einem zweiten Schwingkreis (2), die von spannungsgesteuerten Dioden (3) variabler Kapazität abgestimmt werden, und mit Dioden (6) variabler Kapazität, die den ersten und den zweiten Schwingkreis koppeln, wobei die Dioden (3) variabler Kapazität zur Abstimmung der Schwingkreise und die Dioden variabler Kapazität zur Kopplung zwischen dem ersten und dem zweiten Schwingkreis von der gleichen Steuerspannung (V) gesteuert werden, um die Abstimmung des Filters auf seine Arbeitsfrequenz und die kritische Kopplung der beiden Schwingkreise (1, 2) durchzuführen, dadurch gekennzeichnet, daß die resultierende Koppelkapazität zwischen den beiden Schwingkreisen etwa $Q_c$ mal geringer ist als die resultierende Kapazität, die für die Abstimmung jedes Schwingkreises notwendig ist, wobei $Q_c$ der Überspannungs-Koeffizient des Filters bei Belastung ist.

2. Filter nach Anspruch 1, dadurch gekennzeichnet, daß jeder Schwingkreis eine Induktanz (7) und mindestens ein Paar von gegensinnig angeordneten Dioden (3) variabler Kapazität aufweist, die parallel zur Induktanz geschaltet sind.

3. Filter nach Anspruch 1, dadurch gekennzeichnet, daß jeder Schwingkreis eine Induktanz (7) aufweist, die als Parallelschwingkreis durch Dioden variabler Kapazität (6) abgestimmt wird, die in Reihe mit mindestens einem Kondensator (18) verbunden sind.

4. Filter nach Anspruch 1, dadurch gekennzeichnet, daß die Dioden (6) variabler Kapazität, die den ersten und den zweiten Schwingkreis (1, 2) miteinander koppeln, als gegensinnig in Reihe angeordnete Paare geschaltet sind.

5. Filter nach Anspruch 4, dadurch gekennzeichnet, daß der erste Schwingkreis (1) und der zweite Schwingkreis (2) mit einer Funk-Empfangsantenne (4) bzw. mit dem Eingang eines Funk-Empfängers (5) gekoppelt sind.

## Claims

1. High frequency tunable filter comprising a first (1) oscillating circuit and a second (2) oscillating circuit tuned by voltage-controlled varicap diodes (3), comprising varicap diodes (6) coupled between the first and second oscillating circuits, the varicap diodes (3) for the tuning of the oscillating circuits and the coupling varicap diodes between the first and the second oscillating circuits being controlled by a same control voltage (V) to achieve the tuning of the filter to its working frequency and the critical coupling of the two oscillating circuits (1,2), characterized in that the resultant coupling capacitance between the two oscillating circuits is about $Q_c$ times lower than the resultant capacitance necessary for the tuning of each oscillating circuit, $Q_c$ being the loaded quality factor of the filter.

2. Filter according to Claim 1, characterized in that each oscillating circuit comprises an inductor (7) and at least one pair of varicap diodes (3) mounted head to tail in parallel with the inductor.

3. Filter according to Claim 1, characterized in that each oscillating circuit comprises an inductor (7) tuned in parallel by varicap diodes (6) that are series-connected with at least one capacitor (18).

4. Filter according to Claim 1, characterized in that the varicap diodes (6) coupled between the first and second oscillating circuits (1,2) are mounted in pairs of series-connected diodes mounted head to tail.

5. Filter according to Claim 4, characterized in that the first (1) and second (2) oscillating circuits are coupled respectively to an RF reception antenna (4) and to the input of an RF receiver unit (5).

FIG.1

FIG.3

FIG.2

EP 0 561 676 B1